# EUROPEAN PATENT SPECIFICATION

(11) **EP 2 428 722 B1**
(45) Date of publication and mention of the grant of the patent: **21.11.2012**
(21) Application number: 10175886.0
(22) Date of filing: 09.09.2010
(51) Int. Cl.: F21S 4/00, F21S 8/10

(54) **LED module and packing method of the same**
LED-Modul und Verpackungsverfahren dafür
Module à DEL et son procédé d'emballage

(43) Date of publication of application: 14.03.2012
(73) Proprietor: Long Jing International Technology Enterprise Co., Ltd., Yongkang City (TW)
(72) Inventor: Lee, Hao-An, Yongkang City (TW)
(74) Representative: Viering, Jentschura & Partner

(56) References cited:
- DE-A1-102007 028 097
- DE-U1- 20 004 795
- US-A1- 2003 071 581

## Description

### BACKGROUND OF THE INVENTION

### 1. Field of the Invention

The present invention relates to a LED module and a packing method of the same, particular to a flexible LED module and the packing method of the LED module.

### 2. Description of the Related Art

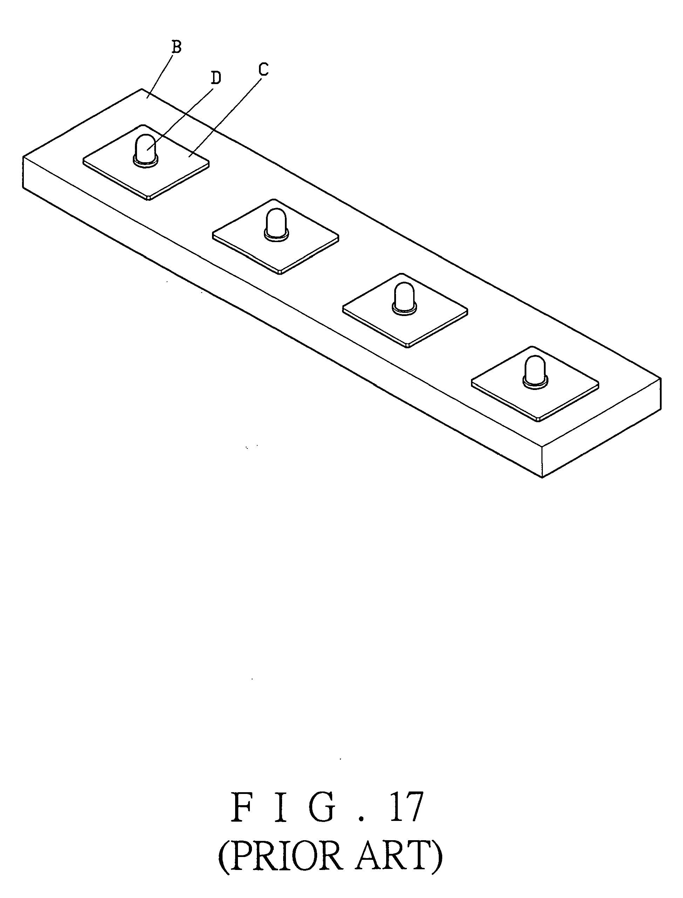

A conventional LED module is shown in Fig. **17** substantially comprising a frame **B**, a circuit board C, and a plurality of lighting units **D**. The lighting units **D** electrically connect to the circuit board **C**. The circuit board C and the lighting units **D** are disposed in the frame **B**. The LED module could be installed on a car and provide lightness to enhance the driving safety. However, some problems still exist in such LED module when in use. The conventional LED module is inflexible and unfoldable. Nonetheless, a car body or a lamp of the car is usually designed into a curved surface. Thus, it is difficult to concentrate the light of each lighting unit of the inflexible LED module to increase the lightness. Moreover, fabricating the LED module involves certain difficulty. Therefore, it is necessary to solve the aforesaid problems. LED modules are disclosed e.g. in DE 200 04 795 U1 and US 2003/071581 A1.

### SUMMARY OF THE INVENTION

In order to solve the problem that the conventional inflexible LED module is difficult to be installed on the curved car body or the car lamp, a LED module packing method according to claim 1 is provided. A LED module according to the present invention is defined in claim 3. The dependent claims show some examples of such a method or module, respectively. The provided LED module is flexible that each LED is able to be installed in accordance with the curved surface of the car body or the car lamp. Moreover, the function of the lamp set is not affected, and the manufacturing cost with respect to the assembling means is reduced. A flexible lamp string formed by the LED module via aforesaid methods is obtainable so as to be installed on the car. The LED module could be installed in accordance with the curved surface of the car body or of the car lamp, thereby serving as a daytime running light or a taillight. No viscose is needed since the present invention utilizes the buckle or the screw to fix the board to the frame or the plaque. Therefore, the original idea and function of the car lamp are not affected.

### BRIEF DESCRIPTION OF THE DRAWINGS

Fig. **1** is a schematic view showing a LED module of the present invention;
Fig. **2** is a schematic view showing a printed circuit board of the present invention;
Fig. **3** is a schematic view showing another printed circuit board of the present invention;
Fig. **4** is a schematic view showing an electronic element and a LED being connected to a board;
Fig. **5** is a schematic view showing a positive guiding line and a negative guiding line being connected to the board;
Fig. **6** is a schematic view showing the electronic element, the LED, a positive guiding line, a negative guiding line being soldered to the printed circuit board, concurrently;
Fig. **7** is a schematic view showing the correlated relationship among each component after each board being separated;
Fig. **8** is a schematic view showing another LED module of the present invention;
Fig. **9** is a schematic view showing another printed circuit board of the present invention;
Fig. **10** is a schematic view showing another printed circuit board of the present invention;
Fig. **11** is a schematic view showing an electronic element and a LED being connected to a board;
Fig. **12** is a schematic view showing another electronic element and another LED being soldered to the printed circuit board, concurrently;
Fig. **13** is a schematic view showing each board being separated to form a LED module unit;
Fig. **14** is a schematic view showing a positive guiding line and a negative guiding line being soldered to the printed circuit board and showing the correlated relationship among each component;
Fig. **15** is a schematic view showing the LED module being installed on a frame or a plaque of a car;
Fig. **16** is a schematic view showing another LED module being installed on a frame or a plaque of a car; and
Fig. **17** is a schematic view showing a conventional LED lamp.

### DETAILED DESCRIPTION OF THE PREFERRED EMBODIMENTS

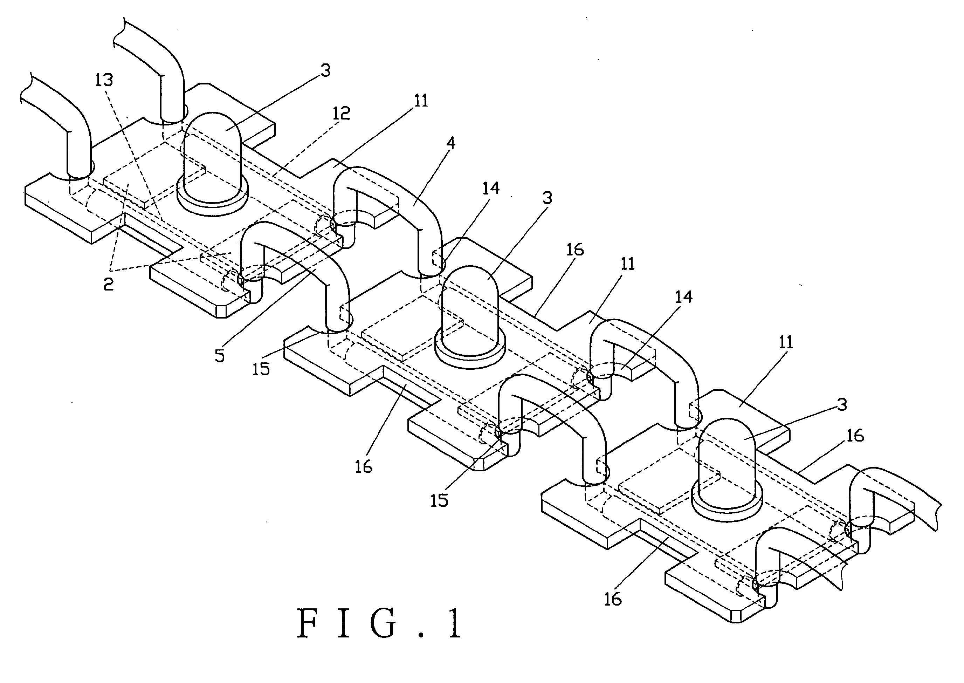

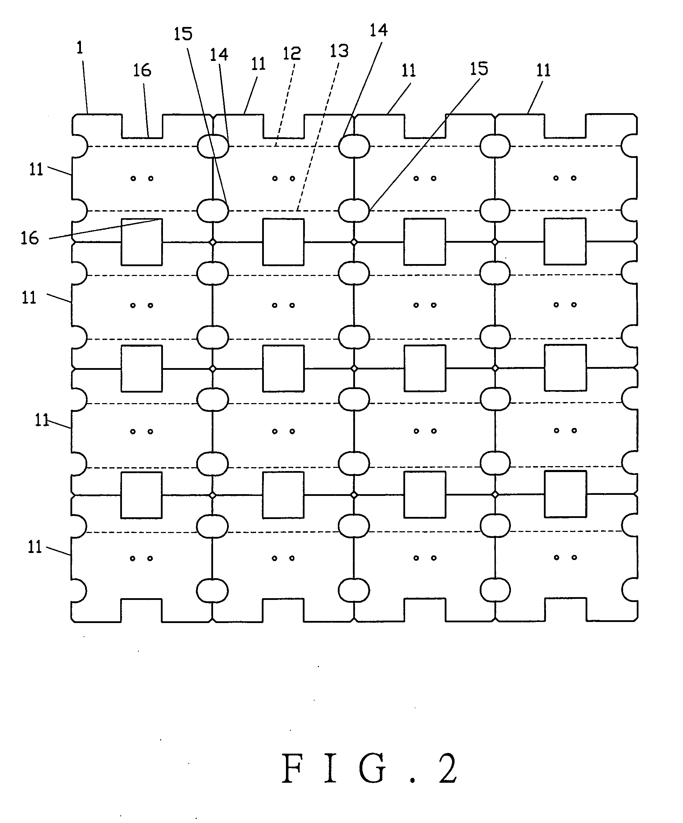

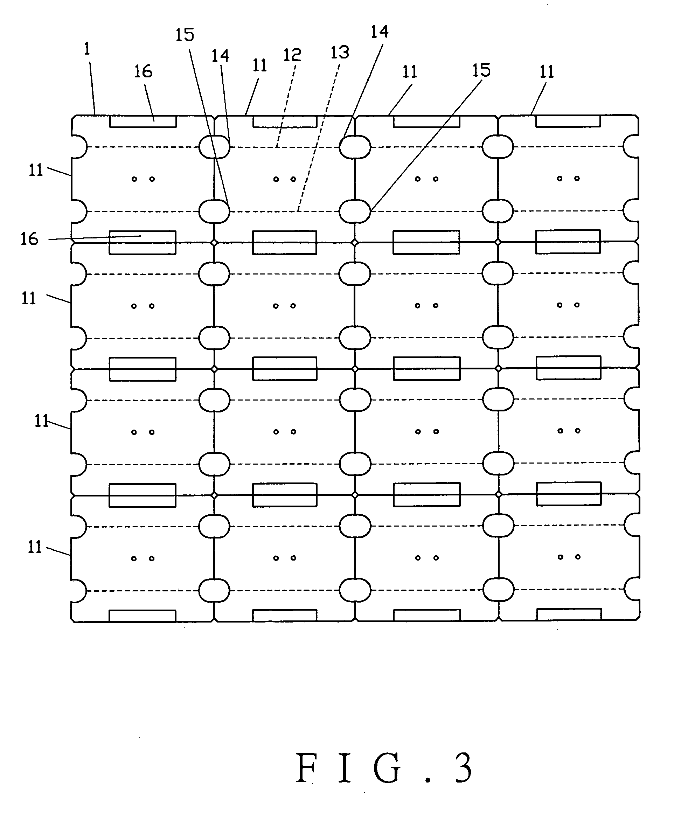

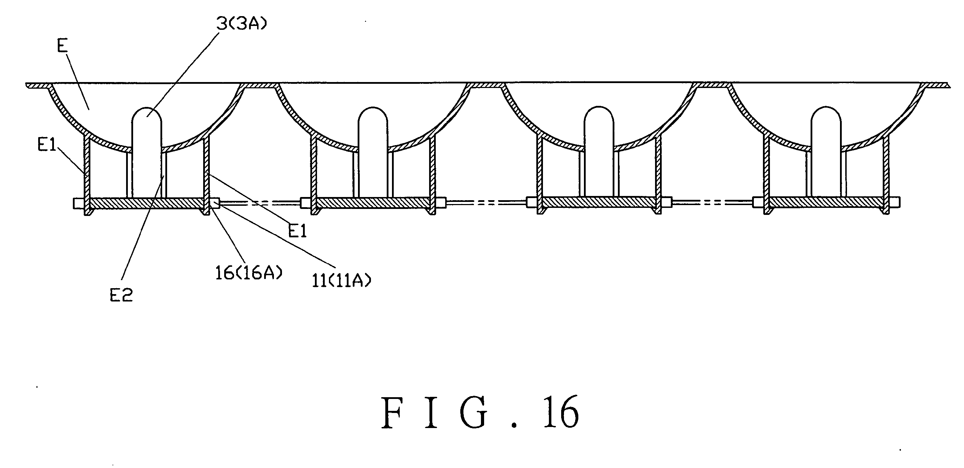

The novel features and inventive steps of the present invention could be clearly performed by referring the following preferred embodiments and the correlated figures. Referring to Fig. **1**, a LED module is applied to a car and is made in accordance with a packing method for the LED module. The method comprises steps of classifying a printed circuit board **1** into a plurality of boards **11** in accordance with a matrix permutation. Either a part of the boards **11** or each board **11** defines a positive line **12** and a negative line **13**. At least one positive joint **14** of the positive line **12** and at least one negative joint **15** of the negative line **13** are defined on a longitudinal end or a lateral end of the board **11**. Fig. **2** shows the preferred embodiment of the present invention that the printed circuit board **1** defines the positive line **12** and the negative line **13** on each board **11**, and the positive joint **14** and the negative joint **15** are respectively disposed on two lateral ends of the board **11**. A fixing portion **16** is disposed on two ends of the board **11** with respect to the positive joint **14** and the negative joint **15**. The fixing portion **16** adopts either a breach, a buckle (as shown in Fig. **3**), or a screw hole. The fixing portion **16** fixes each board **11** to the frame or the plaque **E** of the car. As shown in Figs. **16** and **17**, the fixing portion **16** of the preferred embodiment of the present invention adopts the breach. Thereby, hooks **E1** of the plaque **E** buckle with the fixing portion **16**, and blocking posts **E2** of the plaque **E** further limit the board **11** so as to prevent the board **11** from displacing.

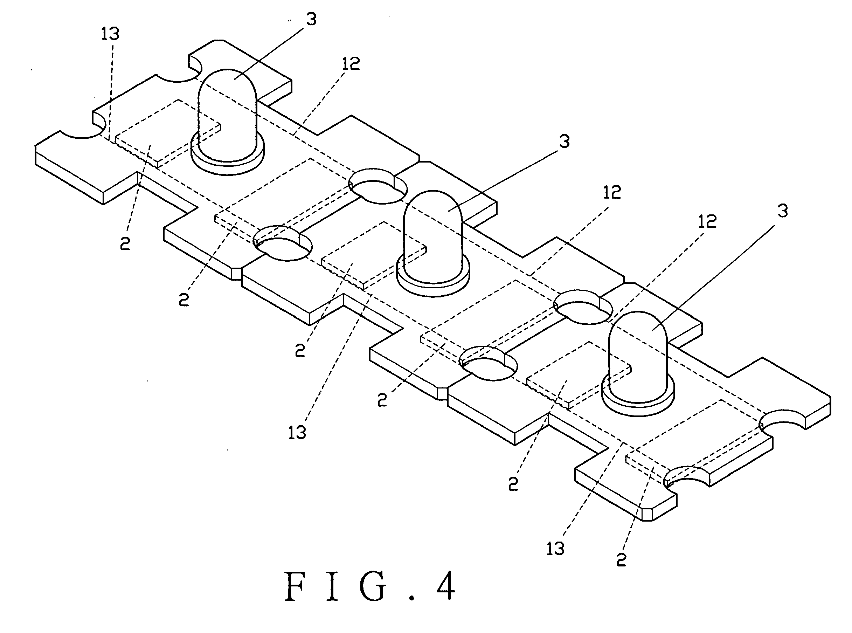

Referring to Fig. **4**, conducting ends of at least one electronic element **2** and at least one LED **3** are connected to the positive line **12** and the negative line **13**, respectively. Wherein, the electronic element **2** adopts an SMD electric resistance and a rectify diode. The electronic element **2** adopts a standard structure in the market, and herein the common function thereof is omitted.

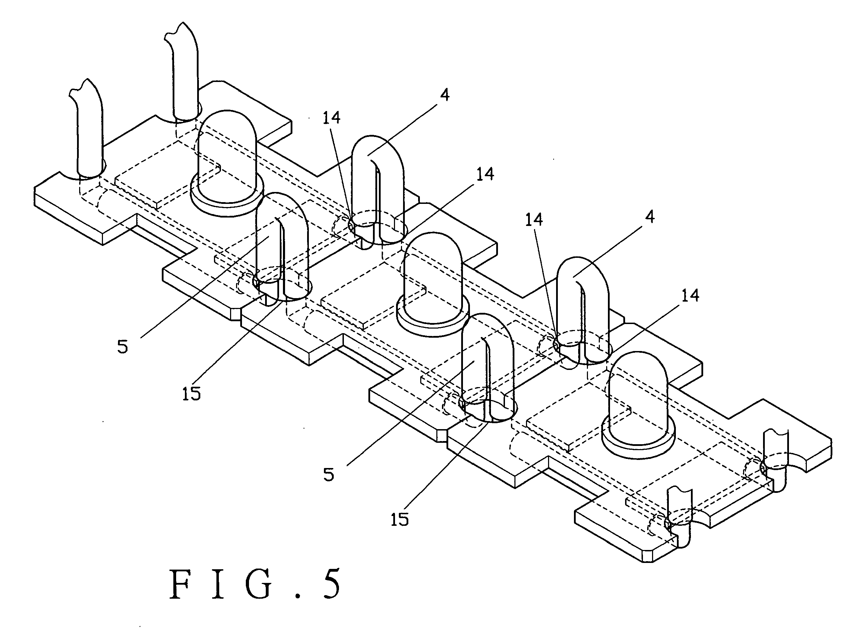

Referring to Fig. **5**, a positive guiding line **4** is connected to each positive joint **14**, and a negative guiding line **5** is connected to each negative joint **15**.

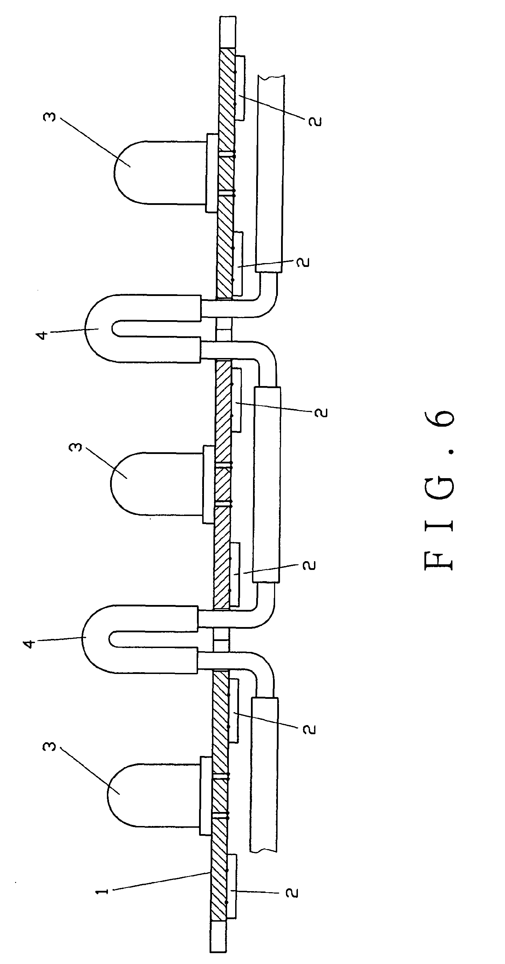

Referring to Fig. **6**, the conducting ends of the electronic element **2** and the LED **3**, the positive guiding line **4**, and the negative guiding line **5** are fixed to the printed circuit board **1**, concurrently. Herein, the concurrent fixing adopts means that the printed circuit board **1** is processed via a tin stove, so that the conducting ends of the electronic element **2** and the LED **3**, the positive guiding line **4**, and the negative guiding line **5** are able to be soldered to the printed circuit board **1**.

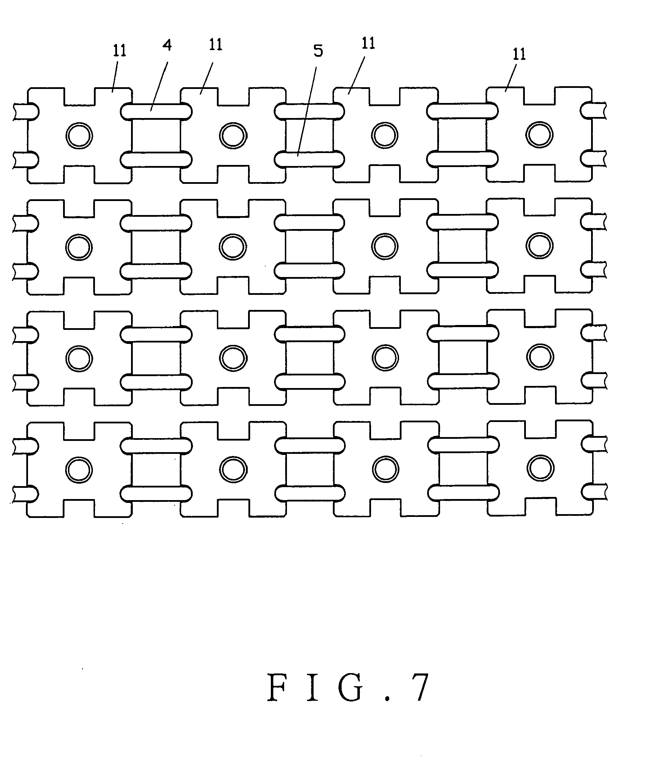

Referring to Fig. **7**, separating each board **11** to form the LED module allows each board **11** to construct a flexible lamp string as shown in Fig. **1**.

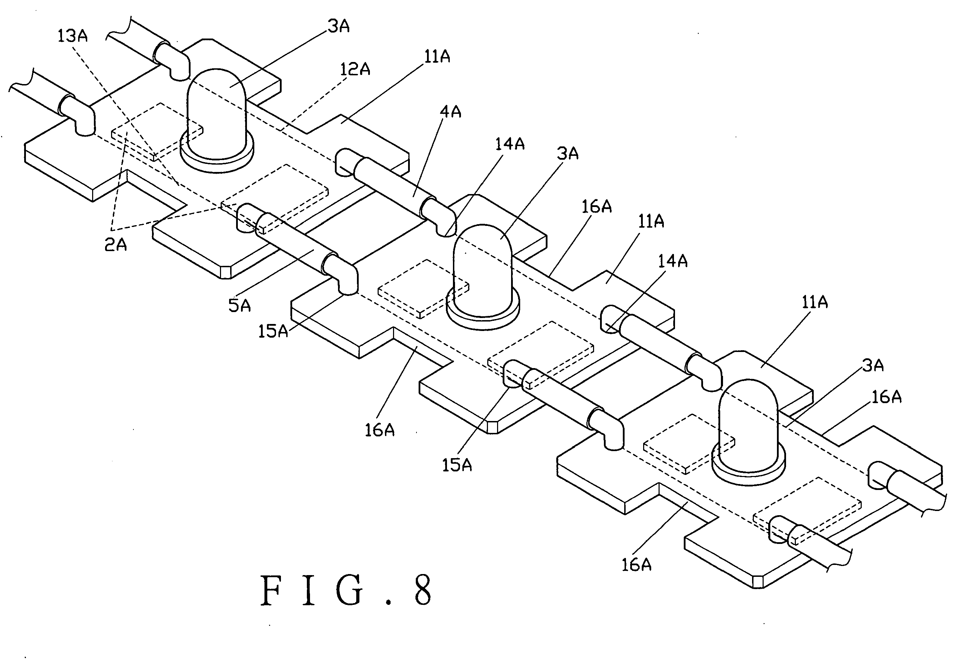

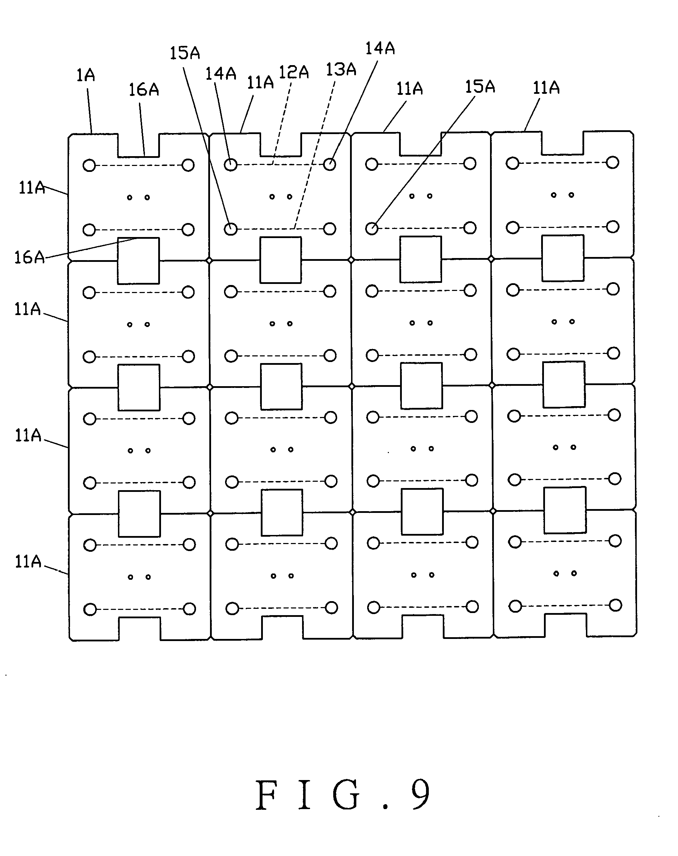

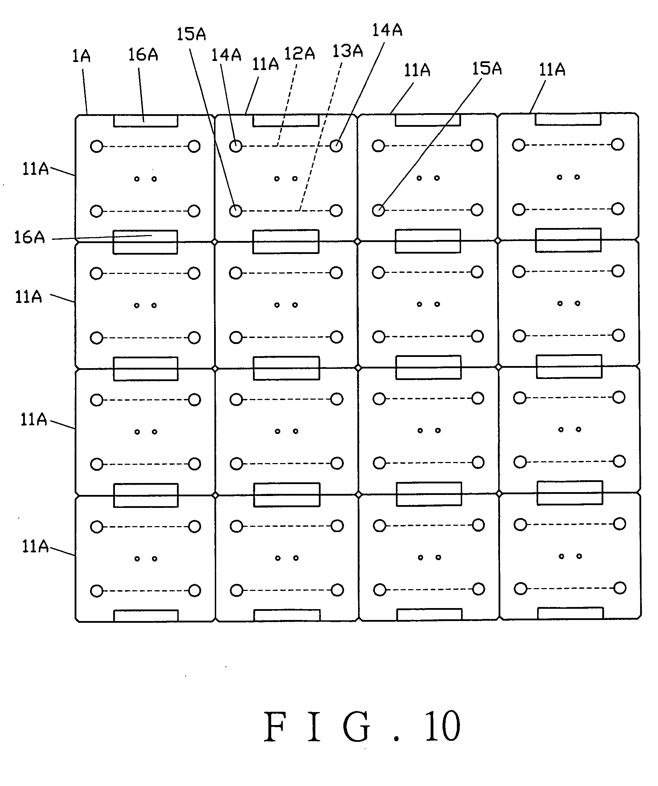

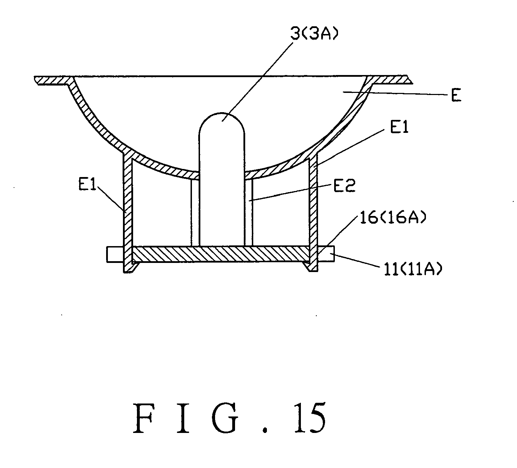

Another preferred embodiment of the present invention is shown in Fig. **8**. A LED module is applied to a car and is made in accordance with a packing method for the LED module. The method comprises steps of classifying a printed circuit board **1A** into a plurality of boards **11A** via a matrix permutation. Each board **11A** defines a positive line **12A** and a negative line **13A**. A positive joint **14A** of the positive line **12A** and a negative joint **15A** of the negative line **13A** are respectively disposed near a longitudinal end or a lateral end of the board **11A**. Referring to Fig. **9**, the printed circuit board **1A** defines the positive line **12A** and the negative line **13A** on each board **11A**, and one positive joint **14A** and one negative joint **15A** are respectively disposed near two lateral ends of the board **11A**. A fixing portion **16A** is disposed on two ends of the board **11A** with respect to the positive joint **14A** and the negative joint **15A**. The fixing portion **16A** adopts a breach, a buckle (as shown in Fig. **10**) or a screw hole. The fixing portion **16A** fixes each board **11A** to the frame or the plaque **E** of the car. As shown in Figs. **15** and **16**, the fixing portion **16A** of the preferred embodiment of the present invention adopts the breach. Thereby, hooks **E1** of the plaque **E** buckle with the fixing portion **16A**, and blocking posts **E2** of the plaque **E** further limit the board **11A** so as to prevent the board **11A** from displacing.

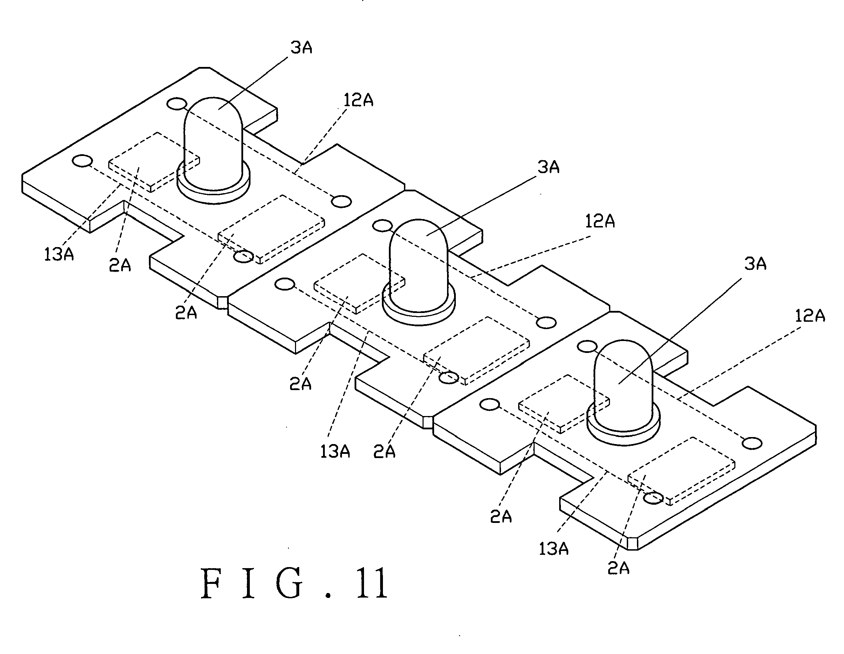

Referring to Fig. **11**, conducting ends of at least one electronic element **2A** and at least one LED **3A** are connected to the positive line **12A** and the negative line **13A**, respectively. Wherein, the electronic element **2A** adopts an SMD electric resistance and a rectify diode. The electronic element **2A** adopts a standard structure in the market, and the conventional function is herein omitted.

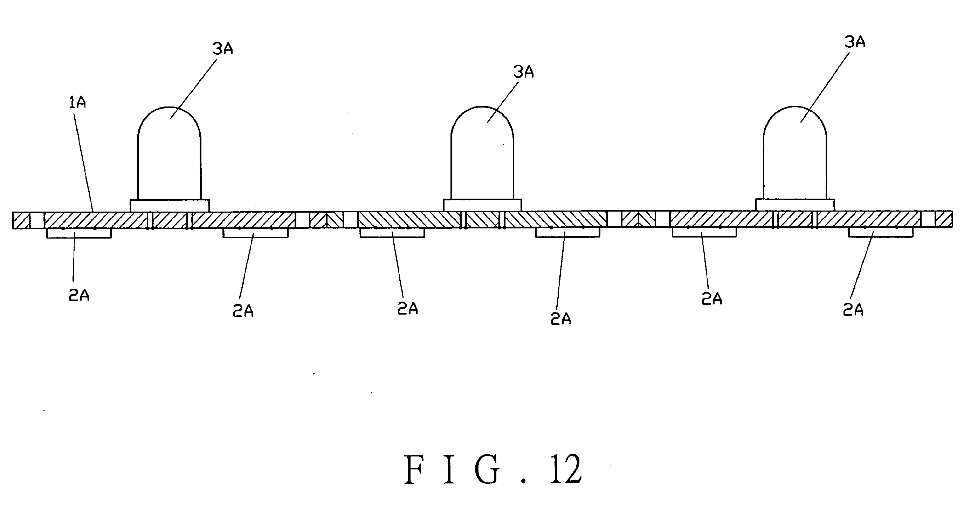

Referring to Fig. **12**, the conducting ends of the electronic element **2A** and the LED **3A** are fixed to the printed circuit board **1A,** concurrently. Herein, the concurrent fixing adopts means that the printed circuit board **1A** is processed via a tin stove, so that the conducting ends of the electronic element **2A** and the LED **3A** are able to be soldered to the printed circuit board **1A.**

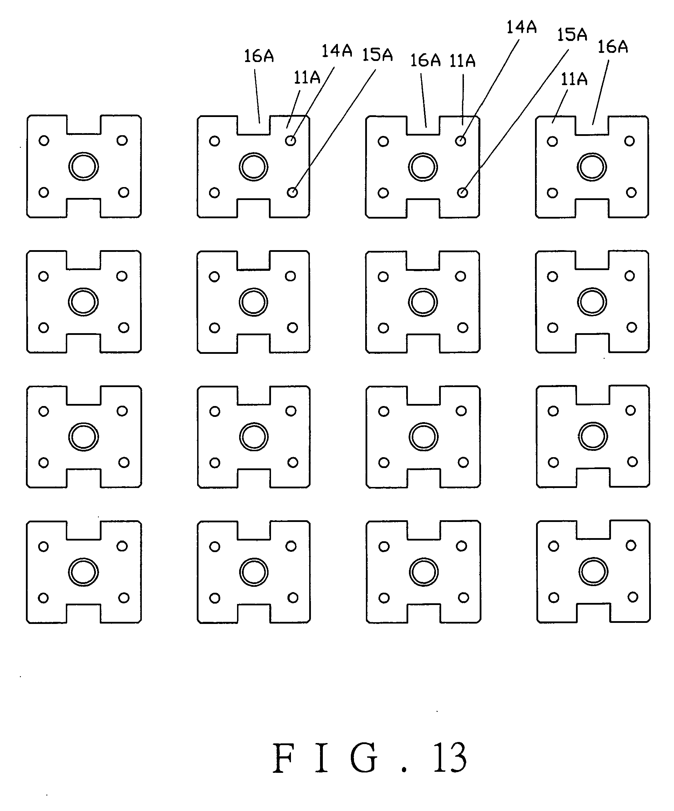

Referring to Fig. **13**, separating each board **11A** constructs a LED module unit.

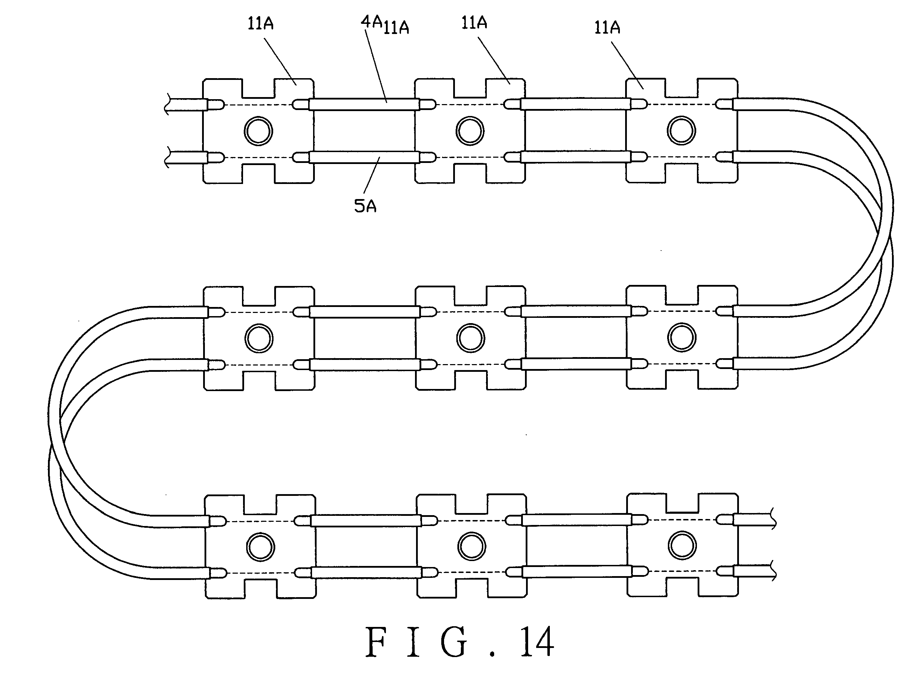

Referring to Fig. **14**, a number of positive guiding lines **4A** are disclosed. Each positive guiding line **4A** is soldered to either the front or the back of the positive joint **14A** of the adjacent board. A number of negative lines **5A** are disclosed. Each of the negative line **5A** is soldered to either the front or the back of the negative joint **15A** of the adjacent board. Thereby, a LED module is formed, and each board **11** is flexible as shown in Fig. **8**. Preferably, a tool (not shown) could be favorably adopted for fixing the board **11** while soldering the board **11**, thereby conveniently soldering the lamp string.

## Claims

1. A method for packing a LED module comprising steps of:
A. classifying a printed circuit board (1A) into a plurality of boards (11A) via a matrix permutation; each board (11A) defining a positive line (12A) and a negative line (13A); a positive joint (14A) of said positive line (12A) and a negative joint (15A) of said negative line (13A) being respectively disposed near a longitudinal end or a lateral end of said board (11A);
B. connecting conducting ends of at least one electronic element (2A) and at least one LED (3A) to said positive line (12A) and said negative line (13A) respectively;
C. fixing said conducting ends of said electronic element (2A) and said LED (3A) to said printed circuit board (1A), concurrently;
D. separating each board (11A)to form a LED module unit; and **characterized in that** it further comprises the steps of:
E. connecting a plurality of positive guiding lines (4A) to said positive joint (14A) of said adjacent board (11A), and connecting a plurality of negative guiding lines (5A) to said negative joint (15A) of said adjacent board (11A), thereby forming a LED module; and a fixing portion (16) is disposed on said ends of said board (11) with respect to said positive joint (14) and said negative joint (15); said fixing portion (16) adopting a breach

2. The method as claimed in claim 1, wherein, said concurrent fixing is achieved by processing said printed circuit board (1A) via a tin stove, thereby fixing said conducting ends of said electronic element (2A) and said LED (3A) to said printed circuit board (1A).

3. A LED module made via said method claimed in claim 1, comprising:
a plurality of boards (11A), each of which defining a positive line (12A) and a negative line (13A); said positive line (12A) connecting to two positive joints (14A), and said negative line (13A) connecting to two negative joints (15A); said two positive joints (14A) and said two negative joints (15A) being situated near two ends of said board (11A), respectively;
a plurality of LEDs (3A) disposed on each board (11A), respectively; conducting ends of said LEDs (3A) being connected to said positive line (12A) and said negative line (13A) respectively;
a plurality of electronic elements (2A) disposed on each board (11A), respectively; conducting ends of said electronic elements (2A) being connected to said positive line (12A) and said negative line (13A) of said board (11A), respectively;
**characterized in that** a fixing portion (16) disposed on said ends of said board (11) with respect to said positive joint (14) and said negative joint (15); said fixing portion (16) adopting a breach; and
a plurality of positive guiding lines (4A), each of which is connected to said positive joint (14A), adjacent to said board (11A); and
a plurality of negative guiding lines (5A), each of which is connected to said negative joint (15A), adjacent to said board (11A).

4. The LED module as claimed in claim 3, wherein, said electronic element (2) adopts an SMD electric resistance and a rectify diode.

## Patentansprüche

1. Eine Methode zum Packen eines LED-Moduls, umfassend die folgenden Schritte:
A. Klassifizieren einer Leiterplatte (1A) in mehrere Platinen (11A) über eine Matrizenpermutation; jede Platine (11A) eine positive Linie (12A) und eine negative Linie (13A) definiert; eine positive Verbindung (14A) der positiven Linie (12A) und eine negative Verbindung (15A) der negativen Linie (13A) sich je in der Nähe eines länglichen Endes oder eines seitlichen Endes der Platine (11A) befinden;
B. Verbinden der leitfähigen Enden von mindestens einem elektronischen Element (2A) und von mindestens einer LED (3A) mit der positiven Linie (12A) bzw. mit der negativen Linie (13A);
C. Gleichzeitiges Befestigen der leitfähigen Enden des elektronischen Endes (2A) und der LED (3A) an die Leiterplatte (1A);
D. Abtrennen einer jeden Platine (11A, um eine LED-Moduleinheit zu bilden; und
**dadurch gekennzeichnet, dass** die Methode die folgenden weiteren Schritte umfaßt:
E. Verbinden von mehreren positiven Führungslinien (4A) mit der positiven Verbindung (14A) der angrenzenden Platine (11A) und Verbinden von mehreren negativen Führungslinien (5A) mit der negativen Verbindung (15A) der angrenzenden Platine (11A), um auf diese Weise ein LED-Modul aufzubauen; ein Befestigungselement (16) ist entsprechend der positiven Verbindung (14) und der negativen Verbindung (15) an den Enden der Platine (11) angeordnet; das Befestigungselement (16) einen Riss aufweist;

2. Die Methode nach Anspruch 1, **dadurch gekennzeichnet, dass** das gleichzeitige Befestigen durch Bearbeiten der Leiterplatte (1A) in einem Zinnofen erfolgt, wobei die leitfähigen Enden des elektronischen Elementes (2A) und das LED (3A) an die Leiterplatte (1A) befestigt werden.

3. Ein LED-Modul, das mit der im Anspruch 1 beschriebenen Methode hergestellt ist, umfassend:
mehrere Platinen (11A), wovon jede Platine (11A) eine positive Linie (12A) und eine negative Linie (13A) definiert; die positive Linie (12A) mit zwei positiven Verbindungen (14A) und die negative Linie (13A) mit zwei negativen Verbindungen (15A) verbunden sind; die beiden positiven Verbindungen (14A) und die beiden negativen Verbindungen (15A) sich in der Nähe zu je einem der beiden Enden der Platine (11A) befinden;
mehrere LEDs (3A), die auf je eine der Platinen (11A) befestigt sind;
die leitfähigen Enden der LEDs (3A) mit der positiven Linie (12A) bzw. mit der negativen Linie (13A) verbunden sind;
mehrere elektronische Elementen (2A), die auf je eine der Platine (11) befestigt sind; die leitfähigen Enden der elektronischen Elemente (2A) mit der positiven Linie (12A) bzw. mit der negativen Linie (13A) der Platine verbunden sind;
**dadurch gekennzeichnet, dass** entsprechend der positiven Verbindung (14) und der negativen Verbindung (15) an den Enden der Platine (11) ein Befestigungselement (16) angeordnet ist; das Befestigungselement (16) einen Riss aufweist; und
mehrere positive Führungslinien (4A), wobei jede dieser positiven Führungslinien (4A) mit der positiven Verbindung (14A) angrenzend zur Platine (11A) verbunden ist; und
mehrere negative Führungslinien (5A), wobei jede dieser negativen Führungslinien (5A) mit der negativen Linie (15A) angrenzend zur Platine (11A) verbunden ist.

4. Das LED-Modul nach Anspruch 3, **dadurch gekennzeichnet, dass** das elektronische Element (2) einen elektrischen SMD-Widerstand und eine Gleichrichterdiode aufweist.

## Revendications

1. Une méthode pour emballer un module DEL comprenant les étapes de :
A. classifier une plaque de circuit imprimé (1A) dans une pluralité de plaques (11A) par une permutation de matrice; chaque plaque (11A) définissant une ligne positive (12A) et une ligne négative (13A) ; une jonction positive (14A) de ladite ligne positive (12A) et une jonction négative (15A) de ladite ligne négative (13A) étant respectivement disposées près d'un bout longitudinal ou un bout latéral de ladite plaque (11A);
B. connecter les bouts conductifs d'au moins un élément électronique (2A) et d'au moins un DEL (3A) respectivement à ladite ligne positive (12A) et à ladite ligne négative (13A) ;
C. simultanément fixer lesdits bouts conductifs du dit élément électronique (2A) et de ladite DEL (3A) à ladite plaque de circuit imprimé (1A) ;
D. séparer chaque plaque (11A) pour former une unité de module DEL ;
et **caractérisé en ce qu'**il encore comprend les étapes de :
E. connecter une pluralité de lignes conductrices positives (4A) à ladite jonction positive (14A) de ladite plaque adjacente (11A), et connecter une pluralité de lignes conductrices négatives (5A) à ladite jonction négative (15A) de la plaque adjacente (11A) pour former un module DEL; et une partie fixée (16) est disposée sur lesdits bouts de ladite plaque (11) selon ladite jonction positive (14) et ladite jonction négative (15) ; ladite partie fixée (16) adoptant un cran ;

2. La méthode selon la revendication 1, dont la fixation est réalisée par traiter ladite plaque de circuit imprimé (1A) par un fourneau de étain, et fixer lesdits bouts conductifs du dit élément (2A) et ladite DEL (3A) à ladite plaque de circuit imprimé (1A).

3. Un module DEL fabriquée par ladite méthode selon la revendication 1, comprenant :
une pluralité de plaques (11A), chaque plaque définissant une ligne positive (12A) et une ligne négative (13A) ; ladite ligne positive (12A) connectant aux deux jonctions positives (14A), et ladite ligne négative (13A) connectant aux deux jonctions négatives (15A) ; lesdites deux jonctions positives (14A) et lesdites deux jonctions (15A) étant respectivement près de deux bouts de ladite plaque (11A) ;
une pluralité de DEL (3A) respectivement disposées sur chaque plaque (11A) ; les bouts conductifs de lesdites DEL (3A) étant respectivement connectés à ladite ligne positive (12A) et ladite ligne négative (13A) ;
une pluralité d'éléments électroniques (2A) respectivement disposées sur chaque plaque (11A) ; les bouts conductifs desdits éléments électroniques (2A) étant respectivement connectés à ladite ligne positive (12A) et ladite ligne négative (13A) de ladite plaque (11A) ;
**caractérisé en ce qu'**une partie fixée (16) disposée sur lesdits bouts de ladite plaque (11) selon ladite jonction positive (14) et ladite jonction négative (15) ; ladite partie fixée (16) adoptant un cran ; et
une pluralité de lignes conductrices positives (4A), chaque ligne est connectée à ladite jonction positive (14A), adjacente à ladite plaque (11A) ; et
une pluralité de lignes conductrices négatives (5A), chaque ligne est connectée à ladite jonction négative (15A), adjacente à ladite plaque (11A).

4. Module DEL selon la revendication 3, dont ledit élément électronique (2) adopte une résistance électrique CMS et une diode de rectification.
